(19) Europäisches Patentamt

European Patent Office

Office européen des brevets

(11) **EP 3 945 629 A1**

(12) **DEMANDE DE BREVET EUROPEEN**

(43) Date de publication:
**02.02.2022 Bulletin 2022/05**

(21) Numéro de dépôt: **21188056.2**

(22) Date de dépôt: **27.07.2021**

(51) Classification Internationale des Brevets (IPC):
**H01P 3/12** *(2006.01)*    **H01P 11/00** *(2006.01)*
**H05K 1/02** *(2006.01)*    **H05K 3/42** *(2006.01)*

(52) Classification Coopérative des Brevets (CPC):
**H01P 11/002; H01P 3/121;** H05K 1/0237;
H05K 3/42; H05K 2201/09618

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **28.07.2020 FR 2007945**

(71) Demandeurs:
- **THALES**
  **92400 Courbevoie (FR)**
- **Université de Bordeaux**
  **33000 Bordeaux (FR)**
- **Institut Polytechnique de Bordeaux**
  **33400 Talence (FR)**

- **Centre national de la recherche scientifique**
  **75016 Paris (FR)**

(72) Inventeurs:
- **MAZEAU, Thierry**
  **33700 MERIGNAC (FR)**
- **TOMÉ, Olivier**
  **33700 MERIGNAC (FR)**
- **GHIOTTO, Anthony**
  **33130 BEGLES (FR)**
- **CARILLON, Guillaume**
  **33700 MERIGNAC (FR)**

(74) Mandataire: **Lavoix**
**2, place d'Estienne d'Orves**
**75441 Paris Cedex 09 (FR)**

(54) **PROCÉDÉ DE FABRICATION D'UN COMPOSANT EN TECHNOLOGIE SIW (GUIDE D ONDE INTÉGRÉ AU SUBSTRAT); COMPOSANTS ET CIRCUITS OBTENUS PAR LA MISE EN UVRE DUDIT PROCÉDÉ**

(57) Ce procédé consiste en : la réalisation (102) d'un composant générique (110) comportant uniquement une pluralité de trous métallisés (121), chaque trou métallisé formant un via entre des première et seconde couches conductrices du composant disposées de part et d'une d'un substrat ; et, la configuration (104) du composant générique de manière à obtenir un composant final (130, 150), en dé-métallisant au moins un trou métallisé de manière à obtenir un trou dé-métallisé (142, 162), les trous métallisés (141, 161) restants étant disposés selon un motif propre à guider les ondes électromagnétiques dans le substrat d'une manière permettant de conférer une fonction caractéristique au composant final.

FIG.2

EP 3 945 629 A1

**Description**

La présente invention concerne le domaine des composants radiofréquences.

Elle concerne plus particulièrement le domaine des composants en technologie « guide d'onde intégré au substrat » - SIW (pour « Substrate Integrated Waveguide » en anglais) du type comportant un substrat, en un matériau diélectrique, et des première et seconde couches, en un matériau conducteur, les premier et seconde couches recouvrant deux faces opposées du substrat.

La pluralité de trous métallisés que comporte le composant constituent des vias entre les première et seconde couches conductrices, qui modifient localement les conditions aux limites qui contraignent la propagation du champ électromagnétique dans le substrat, c'est-à-dire les propriétés du guide d'onde que constitue le composant.

Ainsi, le motif que forme la pluralité de trous métallisés défini la fonction du composant.

Or, les disparités de fabrication d'un composant en technologie SIW nécessitent d'ajuster les paramètres de la fonction réalisée par un composant particulier pour qu'elle corresponde précisément à la fonction souhaitée. Il est ainsi nécessaire de faire des réglages des paramètres comme par exemple l'amplitude, la phase, le couplage, le déphasage, etc. des signaux sortants du composant considéré.

Les documents de l'état de la technique relatifs au réglage des paramètres des composants en technologie SIW sont nombreux. Cependant, ils préconisent d'utiliser des composants additionnels actifs pour régler les paramètres d'un composant en technologie SIW. Par exemple, le document CN106129553 décrit un filtre en technologie SIW, dont la réponse est ajustée par des diodes PIN montées en surface. Par exemple encore, le document CN107394322 décrit un filtre en technologie SIW, dont la réponse est ajustée par des systèmes microélectromécaniques ou MEMS (pour « MicroElectroMechanical Systems » en anglais) montés en surface.

Cette solution n'est pas pratique puisqu'elle nécessite de devoir alimenter ces composants additionnels actifs. De plus, en multipliant les composants, cela pose un problème majeur de fiabilité. Enfin, dans des applications de réception de signaux électromagnétiques par exemple, la tenue en puissance est limitée par les capacités des composants additionnels actifs utilisés.

Le but de cette invention est de résoudre ce problème, notamment en proposant un procédé de fabrication permettant un réglage des paramètres d'un composant permettant d'éviter d'avoir à ajouter ultérieurement des composants actifs.

Pour cela l'invention a pour objet un procédé de fabrication d'un composant en technologie « Substrate Integrated Waveguide » - SIW du type précité, caractérisé en ce qu'il consiste en : la réalisation d'un composant générique comportant uniquement une pluralité de trous métallisés, chaque trou métallisé formant un via entre les première et seconde couches ; et la configuration du composant générique de manière à obtenir un composant final, en dé-métallisant au moins un trou métallisé de manière à obtenir un trou dé-métallisé, les trous métallisés restants étant disposés selon un motif propre à guider les ondes électromagnétiques dans le substrat d'une manière permettant de conférer une fonction caractéristique au composant final.

Suivant des modes particuliers de réalisation, le procédé de fabrication comporte une ou plusieurs des caractéristiques suivantes, prises isolément ou suivant toutes les combinaisons techniquement possibles :

- la pluralité de trous métallisés du composant générique forme un super-motif, le super-motif résultant de la superposition d'une pluralité de motifs, chaque motif étant associé à une fonction possible du composant final, et dans lequel la configuration du composant générique consiste à sélectionner, pour le composant final, une fonction caractéristique parmi les différentes fonctions possibles en dé-métallisant les trous métallisés de la pluralité de trous métallisés qui empêchent de conférer la fonction caractéristique sélectionnée au composant final.

- la pluralité de trous métallisés du composant générique forme un super-motif, le super-motif résultant de la superposition d'une pluralité de motifs, chaque motif étant associé à une valeur possible d'un paramètre de la fonction caractéristique du composant final, et dans lequel la configuration du composant générique consiste à choisir, pour le composant final, une valeur du paramètre de la fonction caractéristique en dé-métallisant les trous métallisés de la pluralité de trous métallisés qui empêchent de conférer la valeur choisie au paramètre de la fonction caractéristique du composant final.

- la réalisation d'un composant générique comporte, pour obtenir chaque trou métallisé de la pluralité de trous métallisés, une étape de perçage du substrat d'un trou initial, puis une étape de métallisation dudit trou initial, et dans lequel, lors de la configuration du composant générique, la dé-métallisation d'un trou métallisé particulier consiste à percer le composant générique, à l'endroit dudit trou métallisé particulier, d'un trou ayant un diamètre plus grand que le trou initial ayant conduit, par métallisation, audit ledit trou métallisé particulier.

- le perçage du substrat pour obtenir un trou initial et/ou le perçage pour obtenir un trou dé-métallisé est réalisé au moyen d'un outil laser, les caractéristiques du faisceau laser étant choisies en fonction des dimensions caractéristiques du perçage à effectuer.

- le procédé comporte une étape initiale de conception du super-motif consistant à optimiser chaque motif du super-motif pour tenir compte de la présence des trous dé-métallisés des autres motifs du super-motif.

L'invention a également pour objet un composant en technologie SIW résultant de la mise en œuvre du procédé de fabrication précédent.

Suivant des modes particuliers de réalisation, le procédé comporte une ou plusieurs des caractéristiques suivantes, prises isolément ou suivant toutes les combinaisons techniquement possibles :

- le composant comporte un substrat, en un matériau diélectrique, et des première et seconde couches, en un matériau conducteur, les première et seconde couches recouvrant deux faces opposées du substrat, le composant comportant une pluralité de trous métallisés, chaque trou métallisé formant un via entre les première et seconde couches, et au moins un trou dé-métallisé, la pluralité de trous métallisés du composant formant un motif propre à guider les ondes électromagnétiques dans le substrat de manière à conférer une fonction caractéristique au composant ;
- la fonction caractéristique du composant est une fonction de filtre, caractérisée par une valeur particulière d'au moins un paramètre de gain, une fonction de ligne de transmission, caractérisée par une valeur particulière d'au moins un paramètre de déphasage, ou une fonction de coupleur, caractérisée par une valeur particulière d'au moins un paramètre de couplage.

L'invention a également pour objet un circuit intégrant le composant en technologie SIW précédent.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :

- la figure 1 est une représentation, en perspective et en coupe partielle, d'un composant en technologie SIW résultant de la mise en œuvre du procédé de configuration selon l'invention ;
- la figure 2 est une représentation schématique d'un premier mode de réalisation du procédé de fabrication selon l'invention permettant de sélectionner une fonction caractéristique parmi plusieurs fonctions caractéristique possibles portées par un composant générique ;
- la figure 3 est une représentation d'une première variante d'un second mode de réalisation du procédé de fabrication selon l'invention permettant d'ajuster le gain d'un composant générique du type filtre ;
- la figure 4 est un graphe représentant le gain en fonction de la fréquence pour un composant résultant de la mise en œuvre du procédé de la figure 3 ;
- la figure 5 est une représentation d'une seconde variante d'un second mode de réalisation du procédé de fabrication selon l'invention permettant d'ajuster le déphasage d'un composant générique du type guide d'ondes ;
- la figure 6 est un graphe représentant le déphasage en fonction de la fréquence pour un composant résultant de la mise en œuvre du procédé de la figure 5 ;
- la figure 7 est une représentation d'une troisième variante d'un second mode de réalisation du procédé de fabrication selon l'invention permettant d'ajuster le couplage d'un composant générique du type coupleur ; et,
- la figure 8 est un graphe représentant le couplage en fonction de la fréquence pour un composant résultant de la mise en œuvre du procédé de la figure 7.

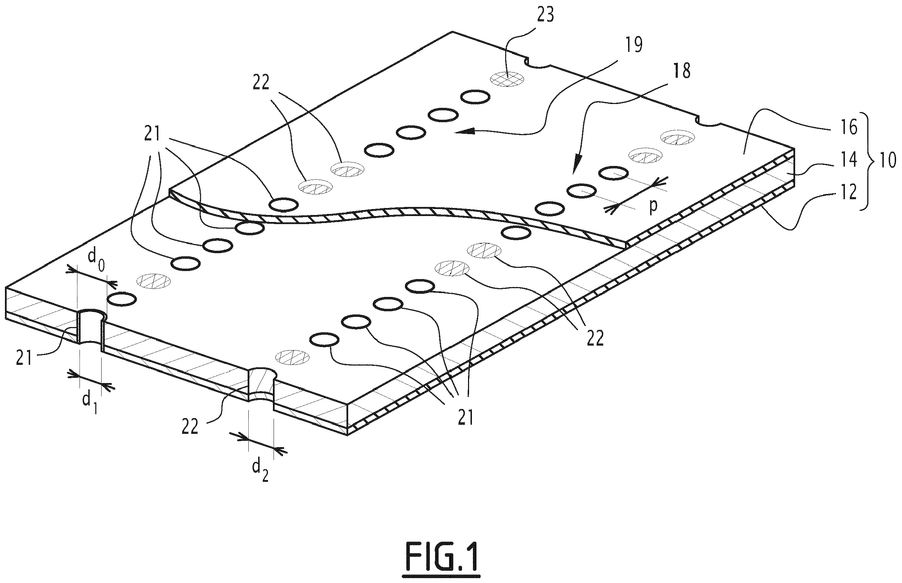

La figure 1 représente un composant 10 en technologie « guide d'onde intégré au substrat » - SIW (pour « Substrate Integrated Waveguide » en anglais).

Le composant 10 comporte un substrat 14, qui est réalisé en un matériau diélectrique. Le substrat 14 présente une faible épaisseur. Il comporte, sur chacune de ses grandes faces, des première et seconde couches conductrices, respectivement 12 et 16, qui sont réalisées en un matériau conducteur du courant électrique, comme un métal, par exemple du cuivre (éventuellement recouvert d'un film de finition).

Le composant 10 comporte une pluralité de trous traversants. Ceux-ci sont de deux sortes : des trous métallisés, référencés par le chiffre 21, ou des trous dé-métallisés, référencés par le chiffre 22.

Un trou métallisé 21 constitue un via établissant une continuité électrique entre les première et seconde couches 12 et 16 à travers le substrat 14.

Un trou métallisé 21 est réalisé par le perçage d'un trou initial de diamètre do dans le substrat 14, puis l'apport d'un matériau conducteur du courant électrique de manière à métalliser la surface intérieure du trou initial et ainsi obtenir un trou métallisé de diamètre $d_1$ ($d_1$ étant inférieur à $d_0$).

De préférence, le matériau conducteur de métallisation du trou initial est identique au matériau utilisé pour réaliser les première et seconde couches conductrices 12 et 16. De préférence, la métallisation des faces du substrat 14 et des différents trous initiaux est réalisée au cours d'une même étape de métallisation.

Un trou dé-métallisé 22 est obtenu à partir d'un trou métallisé 21 correspondant, dont la métallisation a été éliminée de manière à supprimer le contact électrique entre les première et seconde couches 12 et 16 qu'établissait le trou métallisé 21 correspondant. Par exemple, un trou dé-métallisé 22 est réalisé en élargissant le trou métallisé 21 correspondant de manière à être certain de retirer l'intégralité de la métallisation. Le trou dé-métallisé 22 est par exemple obtenu par perçage du trou métallisé 21 correspondant avec un outil permettant de réaliser un trou de diamètre $d_2$. Le diamètre $d_2$ est choisi plus grand que le diamètre dodu trou initial à partir duquel a été obtenu le trou métallisé 21 correspondant, pour être certain d'ôter l'intégralité de la métallisation. Avantageusement, la valeur du diamètre $d_2$ prend en compte les incertitudes sur le centrage de l'outil de perçage par rapport au centre du trou métallisé correspondant à supprimer.

L'outil de perçage est de préférence un outil laser, dont les caractéristiques du faisceau sont adaptées aux dimensions du perçage à effectuer. Incidemment, un laser permet de percer des trous dont la section n'est pas forcément circulaire, par exemple des trous de section ovale ou rectangulaire. En conséquence, ce qui vient d'être décrit dans le cas de trous de section circulaire est immédiatement généralisable à d'autres formes de section de trou. En variante, l'outil de perçage peut être un outil mécanique, par exemple muni d'un foret.

Les trous métallisés 21 sont disposés selon un motif. Par exemple, sur la figure 1, les trous métallisés 21 sont disposées sur deux rangées parallèles, une première rangée 18 et une seconde rangée 19.

De manière générale, la topologie du motif formé par la pluralité de trous métallisés (forme des rangées de trous métallisés, espacement p entre deux trous métallisés successifs le long d'une rangée, l'écartement entre deux rangées, etc.) définit la fonction caractéristique du composant, à la fois dans la nature de cette fonction et dans les valeurs particulières des paramètres de cette fonction.

En effet, les trous métallisés 21 établissent localement un court-circuit entre les deux couches conductrices, de manière à définir des conditions aux limites propres à influencer la manière dont le champ électromagnétique est guidé dans l'épaisseur du substrat 14, entre les couches 12 et 16.

Il est à noter que si un trou métallisé a été dé-métallisé par erreur, il est toujours possible de rétablir un contact électrique entre les première et seconde couches 12 et 16, par exemple au moyen d'une goutte de soudure 23 venant combler le trou dé-métallisé. Alternativement, un rivet ou un fil traversant peut être utilisé.

De manière générale, le procédé de fabrication selon l'invention consiste d'abord à fabriquer un composant générique dont l'ensemble des trous sont des trous métallisés. Les trous métallisés forment un super-motif à la surface du composant générique.

Le procédé de fabrication consiste ensuite à convertir certains des trous métallisés en trous dé-métallisés de manière à configurer le composant générique pour obtenir un composant final exhibant une fonction caractéristique.

La configuration peut s'entendre à deux niveaux. Dans un premier mode de réalisation du procédé de fabrication, il s'agit de la sélection d'une fonction particulière parmi une pluralité de fonctions possibles. Le super-motif du composant générique résulte alors de la superposition des motifs associés à chacune des fonctions possibles que l'on peut conférer au composant final. Les trous métallisés des motifs associés aux fonctions possibles qui ne sont pas retenues lors de la configuration du composant sont dé-métallisés, et seuls sont conserver les trous métallisés associés au motif de la fonction retenue pour le composant final (ou, tout au moins, les trous métallisés qui empêchent le composant de réaliser la fonction retenue sont dé-métallisés).

Dans un second mode de réalisation du procédé de fabrication, il s'agit du réglage d'au moins un paramètre de la fonction caractéristique du composant final. Le super-motif résulte alors à la superposition de différentes variantes du motif associé à la fonction, chaque variante correspondant à une valeur possible dudit paramètre. Les trous métallisés des variantes associées à des valeurs qui ne sont pas retenus pour ledit paramètre sont dé-métallisés lors de la configuration, et seuls sont retenus les trous métallisés correspondant à la variante du motif permettant de conférer une valeur spécifique audit paramètre de la fonction (ou, tout au moins, les trous métallisés qui empêchent le composant de réaliser la fonction caractéristique avec la valeur retenue pour le paramètre de la fonction sont dé-métallisés).

Evidemment, en variante, le procédé de fabrication peut associer ces deux manières de configurer le composant générique.

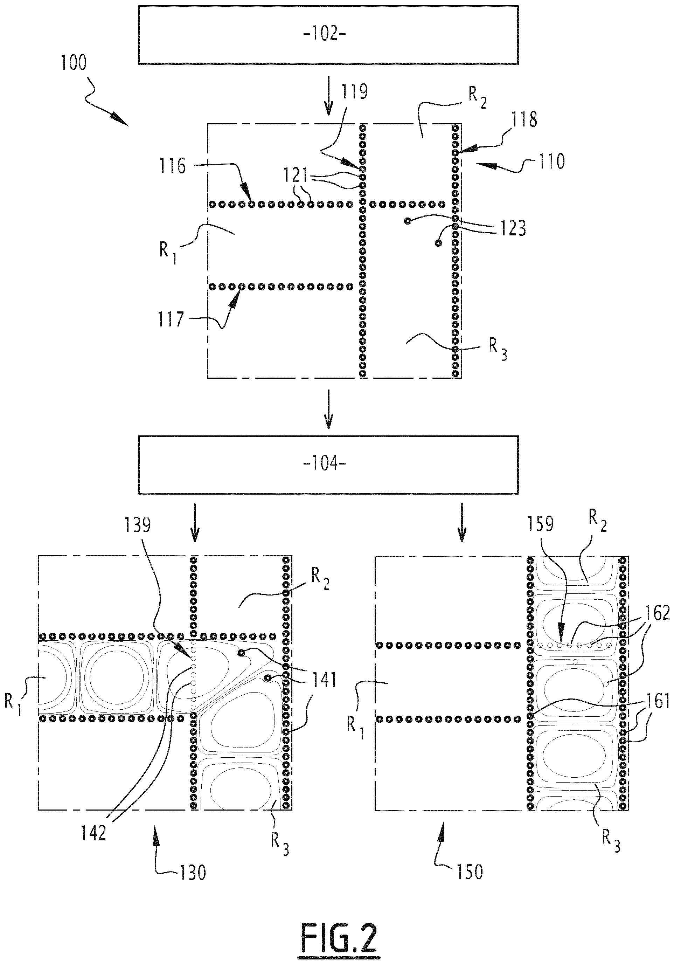

En se référant à la figure 2, le procédé de configuration 100 consiste à sélectionner une fonction caractéristique parmi deux fonctions possibles.

Le procédé 100 comporte une première étape 102 de réalisation d'un composant générique 110 comportant uniquement des trous métallisés 121. Les trous métallisés forment un super-motif résultant de la superposition d'un premier motif associé à la première fonction et d'un second motif associé à la seconde fonction.

Le premier motif est constitué de deux rangées de trous métallisés 121, coudées à 90°, respectivement 116 et 117, de manière à former un guide d'onde permettant de réaliser la première fonction consistant à transmettre un signal appliqué à l'entrée de la troisième région $R_3$ vers la sortie de la première région $R_1$. Avantageusement, le premier motif comporte deux trous métallisés supplémentaires 123 disposés au voisinage de la portion coudée de la rangée 116.

Le second motif est constitué de deux rangées rectilignes de trous métallisées 121, respectivement 118 et 119, de manière à former un guide d'onde permettant de réaliser la seconde fonction consistant à transmettre un signal appliqué à l'entrée de la troisième région $R_3$ vers la sortie de la seconde région $R_2$.

Les premier et second motifs se confondent partiellement pour délimiter la troisième région $R_3$.

Le procédé 100 se poursuit par une l'étape 104 de configuration du composant générique 110 de manière à obtenir soit un premier composant 130 réalisant la première fonction de transmission, soit un second composant 150 réalisant la seconde fonction de transmission.

Le premier composant 130 comporte des trous métallisés 141 et des trous dé-métallisés 142. Il est obtenu à partir du composant générique 110 en dé-métallisant les trous métallisés du second motif, ou plus simplement les trous métallisés qui empêchent la propagation du champ électromagnétique de la troisième région R$_3$ vers la première région R$_1$, c'est-à-dire les trous du segment 139 de la rangée 119. En revanche les autres trous du super-motif restent des trous du type métallisé 141, notamment, les deux trous métallisés supplémentaires 123 dans la partie coudée du premier motif qui permettent de modifier les conditions aux limites afin d'aider à guider l'onde selon un chemin à 90°.

De manière similaire, le second composant 150 comporte des trous métallisés 161 et des trous dé-métallisés 162. Il est obtenu à partir du composant générique 110 en dé-métallisant les trous métallisés du premier motif, ou, plus simplement, les trous métallisés du premier motif qui empêchent la propagation du champ de la troisième région R$_3$ vers la seconde région R$_2$, c'est-à-dire les trous du segment 159 de la rangée 116, ainsi que les deux trous métallisés supplémentaires 123 dans la partie coudée du premier motif. En revanche les autres trous du super-motif restent des trous du type métallisé 161.

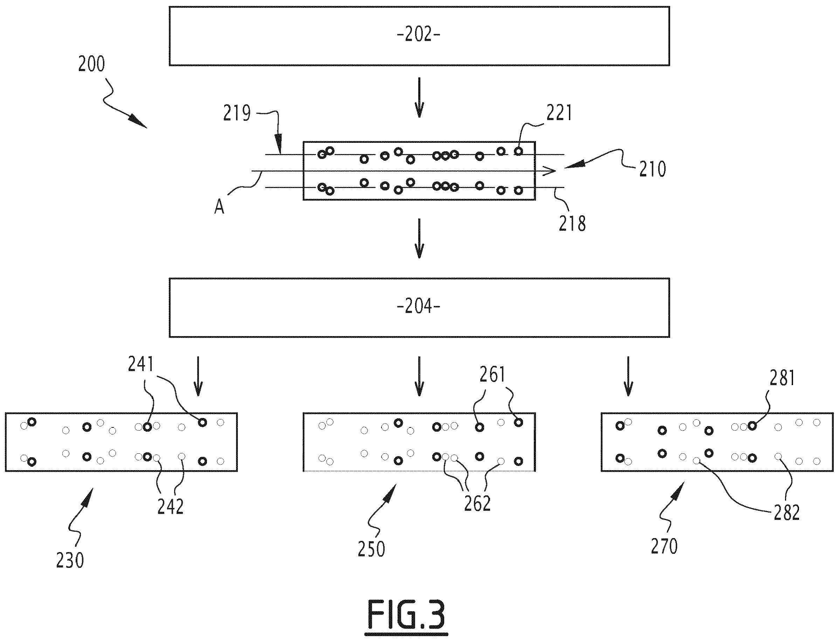

En se référant à la figure 3, le procédé de fabrication 200 débute par une étape de réalisation 202 d'un composant générique 210. Le composant générique 210 porte un super-motif correspondant à différentes variantes d'une fonction caractéristique du type filtre. Chaque variante est associée à une valeur particulière d'un paramètre de gain de la fonction caractéristique. L'article F. Parment, A. Ghiotto, T.P. Vuong, J.M. Duchamp, and K. Wu, "Low-loss air-filled substrate integrated waveguide (SIW) band-pass filter with symmetric inductive posts," Oral, 45rd IEEE European Microwave Conférence (EuMC), Paris, 6-11 Sep. 2015. (DOI: 10.1109/EuMC.2015.7345875 - IEEE Xplore) explique la manière dont on peut déterminer théoriquement les positions des vias d'un motif à partir d'un modèle électrique du filtre.

Le composant générique 210 présente uniquement des trous métallisés 221, qui sont ici disposés symétriquement de part et d'autre d'un axe longitudinal A du composant générique 210. En variante, le composant pourrait ne pas être symétrique.

Les trous métallisés 221 ne sont pas strictement alignées sur deux rangées parallèles, 218 et 219, mais avec une certaine distribution autour de ces rangées.

Le procédé 200 se poursuit par une étape de configuration 204 consistant à ajuster la valeur du paramètre de gain de la ligne de transmission en venant dé-métalliser, de manière symétrique par rapport à l'axe A, certains trous métallisés 221 du composant générique 210.

Un premier circuit final 230 peut être obtenu. Il comporte des trous métallisés 241 et des trous dé-métallisés 242.

Un second circuit final 250 peut être obtenu. Il comporte des trous métallisés 261 et des trous dé-métallisés 262.

Un troisième circuit final 270 peut être obtenu. Il comporte des trous métallisés 281 et des trous dé-métallisés 282.

Les motifs formés par les trous métallisés restants diffèrent d'un circuit 230, 250 et 270 à l'autre. Ils correspondent chacun à une variante de la fonction et par conséquent à un gain du filtre.

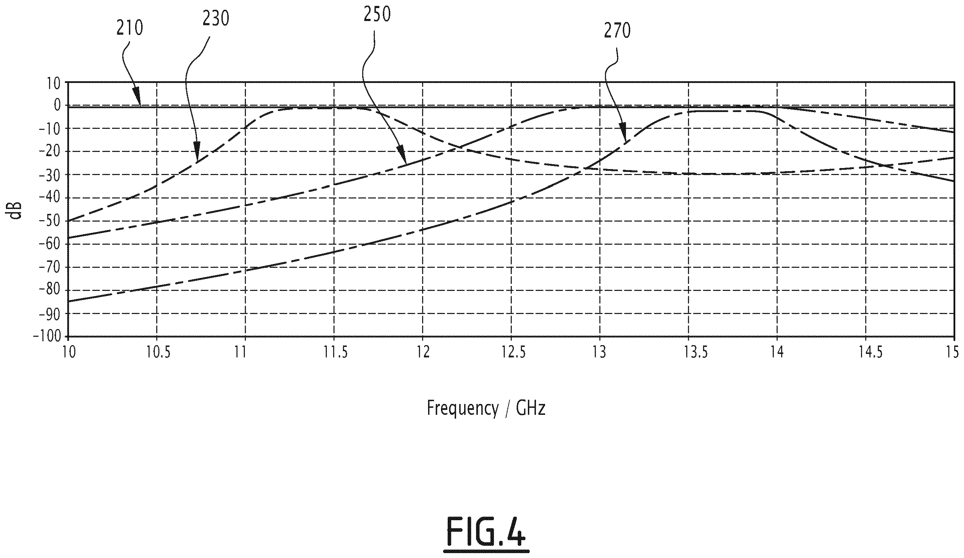

Ces gains sont représentés sur la figure 4 en fonction de la fréquence. Sur ce graphe. Ainsi, en fonction de la position des trous dé-métallisés et métallisés le maximum du gain est obtenu pour des fréquences caractéristiques qui diffèrent d'un composant à l'autre.

Ainsi, l'opérateur choisit la valeur du gain du circuit final qu'il fabrique en dé-métallisant certains trous métallisés plutôt que d'autres.

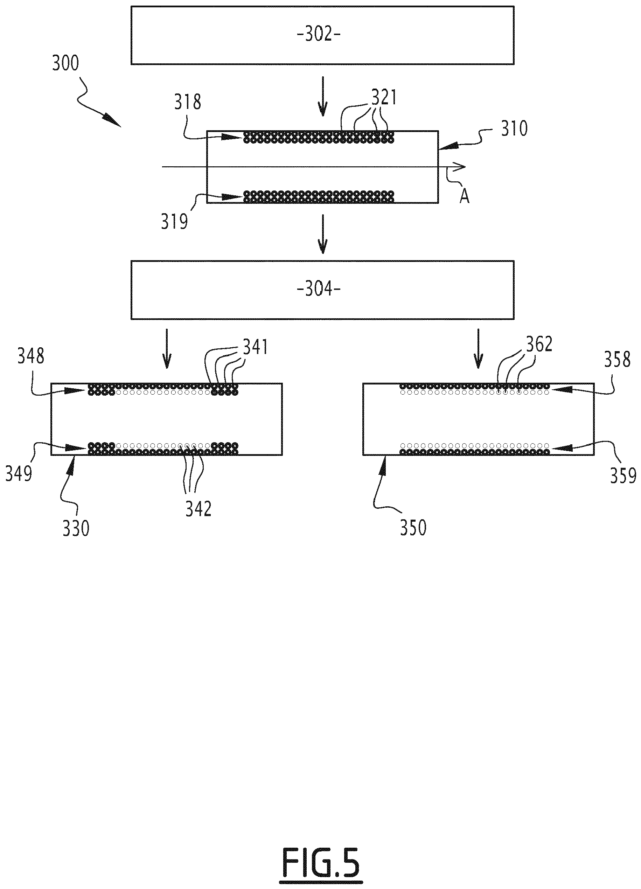

En se référant à la figure 5, le procédé de fabrication 300 débute par une étape de réalisation 302 d'un composant générique 310 réalisant une fonction de déphaseur. Les trous métallisés 321 du composant générique 310 forment un super-motif constitué de deux rangées, 318 et 319, disposées parallèlement l'une de l'autre de part et d'autre d'un axe longitudinal A du composant générique 310. Au-delà des rangées 318 et 319 par rapport à l'axe A, sont prévues des rangées de trous métallisés pour délimiter la largeur maximale du guide d'onde.

Les trous métallisés d'une même rangée sont par exemple espacés les uns des autres par un pas constant et faible.

Le procédé 300 se poursuit par une étape de configuration 304 consistant à venir dé-métalliser un ensemble de trous métallisés des rangées 318 et 319 pour ajuster la valeur du déphasage introduit par le guide d'onde entre le signal délivré en sortie par rapport au signal appliqué en entrée.

Il est ainsi possible de fabriquer un premier composant final 330 comportant deux rangées de trous, 348 et 349, chaque rangée comportant des trous métallisés 341 sur ses portions d'extrémité et des trous dé-métallisés 342 sur sa portion centrale.

Il est également possible de fabriquer un second composant final 350 en dé-métallisant l'ensemble des trous métallisés des rangées 318 et 319 du composant générique 310. Le second composant final 350 comporte des rangées 358 et 359 constituées uniquement de trous dé-métallisés 362.

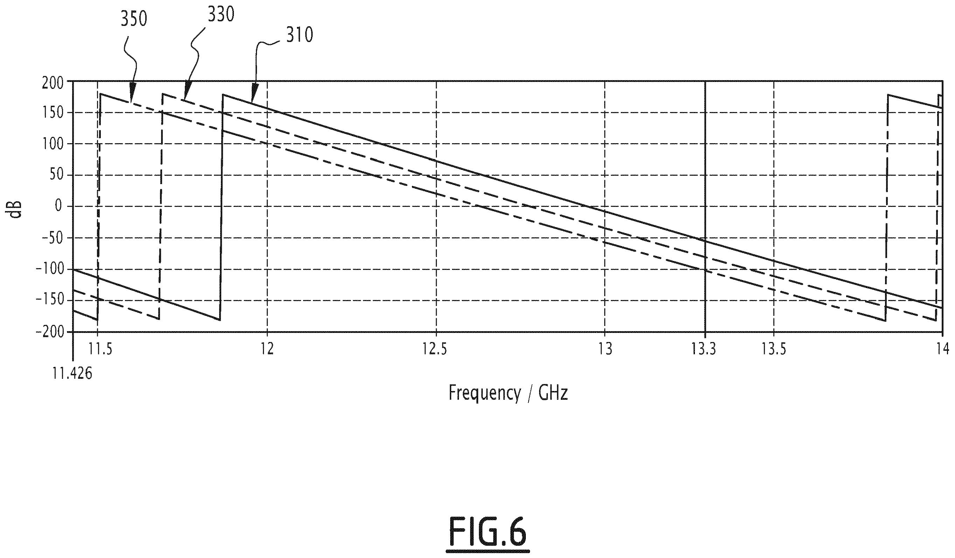

Le graphe de la figure 6 montre l'évolution du déphasage introduit par chacun des composants 310, 330, et 350 en fonction de la fréquence du signal d'entrée. On constate par exemple, pour la valeur 13.3 GHz de la fréquence, que le déphasage introduit par le composant générique 310 est d'environ -55°, que le déphasage introduit par le premier composant final 330 est d'environ -78° et que le déphasage introduit par le second composant final 350 est d'environ -100°.

Ainsi, dans cette variante de réalisation du procédé de fabrication, le paramètre de déphasage du guide d'onde peut être ajusté en dé-métallisant certains des trous métallisés du composant générique. Le super-motif correspond ici à la superposition des motifs des différentes variantes de la fonction guide d'ondes, chaque variante correspondant à une valeur du déphasage.

Plus précisément et pour illustrer la relation entre les paramètres topologiques d'un motif et les propriétés de la fonction associée, la distance p entre deux trous métallisés d'une rangée, le rayon do de chaque trou métallisé (évalué à l'interface entre la métallisation et le substrat), ainsi que la largueur W entre les deux rangées opposées permet de calculer une largeur effective selon la relation suivante :

$$Weff = W - ((d_0)^2/(0.95{}^*p)$$

où Weff est la largueur équivalente désirée d'un guide d'onde conventionnelle rempli du même matériau diélectrique que celui dont est fait le substrat 14.

Afin d'éviter les pertes par radiation entre les vias, on choisit do et p de sorte que :

$$p / d_0 < 2{,}5$$

La constante de phase du mode TE10 de propagation du champ électromagnétique dans le guide d'onde est donnée par la relation suivante :

$$\beta = \sqrt{\left(\frac{2\pi f \sqrt{\varepsilon_r}}{c}\right)^2 - \left(\frac{\pi}{Weff}\right)^2}$$

avec f la fréquence, c la vitesse de la lumière et $\varepsilon_r$ la permittivité relative du substrat 14.

Ainsi, en changeant localement la largeur effective Weff par la dé-métallisation de vias, on change la constante de phase, ce qui introduit un déphasage.

Le déphasage total est alors donné par la relation :

$$\Phi = (\beta_1 - \beta_2) * l$$

avec $\beta_1$ la constante de phase pour la section du guide d'onde qui conserve les vias métallisés, et $\beta_2$ la constante de phase pour la section du guide d'onde pour laquelle on a enlevé les vias métallisés, et l la longueur sur laquelle on a supprimé les vias métallisés.

Ces résultats sont pat exemple présentés dans l'article M. Bozzi, A. Georgiadis and K. Wu, "Review of substrate-integrated waveguide circuits and antennas," in IET Microwaves, Antennas & Propagation, vol. 5, no. 8, pp. 909-920, 6 June 2011, doi: 10.1049/iet-map.2010.0463, ou encore dans l'article M. Bozzi, M. Pasian, L. Perregrini, and K. Wu, "On the Losses in Substrate Integrated Waveguides and Cavities," International Journal Microwave and Wireless Technologies, 2009.

On notera que plus la portion centrale de chaque rangée délimitant le guide d'onde, qui est constituée de trous dé-métallisés, est étendue, plus le déphasage est important.

Le réglage du déphasage peut être très fin puisqu'il peut consister à étendre trou par trou l'étendue de la portion centrale de chaque rangée. Par exemple, à chaque dé-métallisation d'un via, l'opérateur peut mesurer la valeur du déphasage sur un banc test et choisir de poursuivre la dé-métallisation pour atteindre la valeur souhaitée du déphasage.

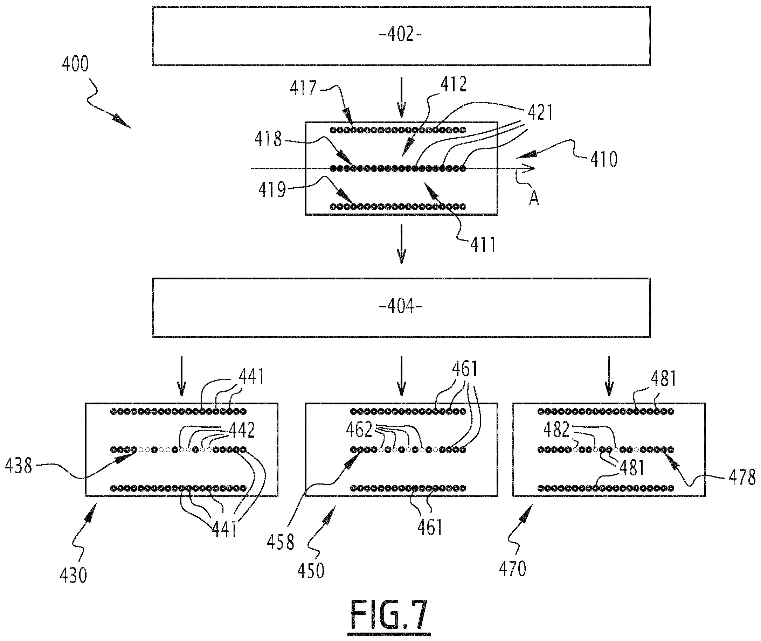

Sur la figure 7, le procédé de fabrication 400 permet de régler le paramètre de couplage dans un composant réalisant la fonction caractéristique de coupleur.

Le procédé 400 débute par une étape de réalisation 402 d'un composant générique 410.

La pluralité de trous métallisés 421 forment un super-motif constitué de trois rangées 417, 418 et 419, disposées parallèlement. La rangée centrale s'étend sur l'axe longitudinal A du composant générique. Les rangées supérieure et inférieure, 417 et 419, sont ici à une même distance de la rangée centrale 418, mais pourraient en variante être à des distances différentes de la rangée centrale.

Ainsi, la rangée centrale 418 et la rangée supérieure 417 définissent un premier guide d'onde 412, tandis que la rangée centrale 418 et la rangée inférieure 419 définissent un second guide d'onde 411.

La rangée centrale 418 est « continue » de sorte qu'il n'y a aucun couplage entre les premier et second guide d'onde 411 et 412 dans le composant générique.

Le procédé 400 se poursuit par une étape de configuration 404 permettant d'ajuster la valeur du couplage entre les premier et second guide d'onde en créant des ouvertures dans la rangée centrale.

Par exemple, il est possible d'obtenir un premier circuit final 430. Celui-ci comporte des trous métallisés 441 et des trous dé-métallisés 442. Les trous dé-métallisés sont obtenus en dé-métallisant une fraction des trous métallisés de la rangée centrale 438 de manière à créer une fuite entre les premier et les second guides d'onde. Par exemple, dans une portion centrale de la rangée centrale 438, deux trous sur trois sont du type dé-métallisés.

De manière similaire, il est possible d'obtenir un second circuit final 450, qui comporte des trous métallisés 461 et des trous dé-métallisés 462. Dans une portion centrale de la rangée centrale 438, c'est un trou sur deux qui est du type dé-métallisé.

Enfin, il est possible d'obtenir un troisième circuit final 470, qui comporte des trous métallisés 481 et des trous dé-métallisés 482. Dans une portion centrale de la rangée centrale 478, c'est un trou sur trois qui est du type dé-métallisé.

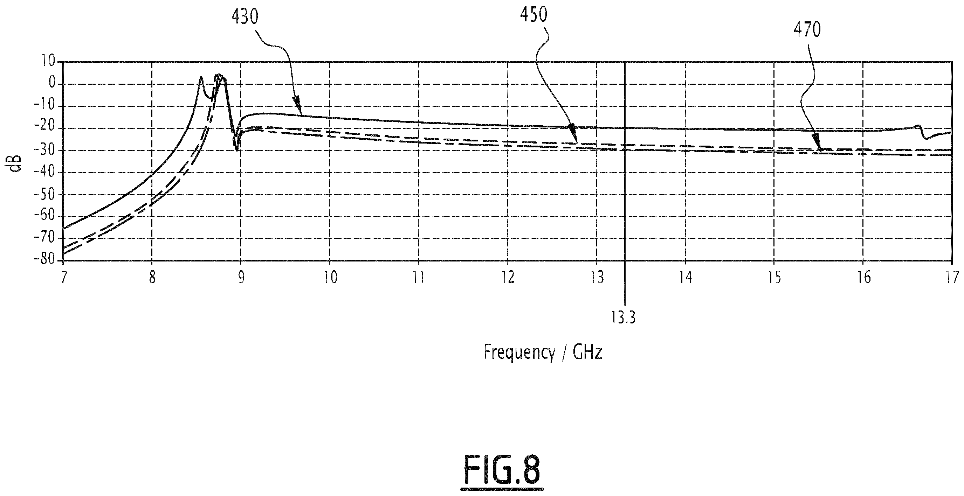

On a représenté sur la figure 8 le couplage (exprimé en décibels) des premier, second et troisième circuits 430, 450 et 470. Par exemple, pour la fréquence 13,3 GHz, le premier circuit final 430 présente un couplage d'environ -20 dB, le second circuit final 450 présente un couplage d'environ -25 dB, et le troisième circuit final 470 présente un couplage d'environ -30 dB environ.

Plus la fuite entre les deux guides d'ondes du composant est importante, plus le couplage est important.

Ainsi par la mise en œuvre du procédé de configuration 400 permet à l'opérateur d'ajuster la valeur du paramètre de couplage d'un composant du type coupleur.

Le réglage peut être très fin puisqu'à chaque dé-métallisation d'un trou métallisé, l'opérateur peut mesurer la valeur du couplage sur un banc test et choisir de poursuivre la dé-métallisation pour atteindre la valeur souhaitée du couplage.

De manière particulièrement avantageuse, en amont des étapes de fabrication du procédé selon l'invention, une étape de conception de la topologie du super-motif est réalisée. Elle consiste par exemple à concevoir séparément une première version de chacun des motifs des différentes fonctions (ou variantes de fonction) réunies sur le composant générique. Puis, pour une fonction particulière, la première version du motif correspondant est modifiée en insérant des trous demétallisés selon les premières versions des motifs des autres fonctions. On ajuste ensuite la réponse de cette version modifiée du motif en déplaçant les trous métallisés pour prendre en compte les ouvertures résultant de la présence des trous dé-metallisés. On obtient ainsi une seconde version du motif associé à chaque fonction. On réitère ces étapes pour converger vers des motifs permettant d'obtenir les fonctions désirées, ces motifs étant optimisés pour prendre en compte la présence des trous démétallisés.

La mise en œuvre du présent procédé de fabrication permet de rectifier les erreurs ou les disparités affectant la fabrication industrielle d'un composant en technologie SIW. On obtient des séries de composants avec une très faible disparité de leurs propriétés.

Le présent procédé permet également de réaliser un composant générique en grande série. Cela permet de réduire les coûts de fabrication. Puis, en fonction des besoins spécifiques d'un utilisateur ou d'une application, de configurer un plus petit nombre de composants.

La présente invention peut être appliquée en reprenant les motifs des fonctions réalisées par les composants de l'état de la technique, de manière notamment à permettre l'ajustement de leurs paramètres.

Dans la présente description, le cas d'un composant, qui est propre à réaliser une unique fonction a été présenté. Mais, l'invention s'étend directement aux circuits en technologie SIW, qui intègrent, sur un même substrat, plusieurs composants, i.e. plusieurs fonctions. Par exemple, un circuit peut comporter un premier composant du type du composant 130 et un second composant du type du composant 230.

On peut également combiner la présente invention avec des composants actifs qui, sont mis en œuvre dans l'état de la technique pour ajuster le ou les paramètres d'une fonction. Par exemple, la présente invention est utilisée pour choisir une fonction parmi une pluralité de fonctions possibles, puis des composants actifs sont montés sur le composant final pour en ajuster les paramètres.

Par exemple encore, au lieu de chercher à ajuster deux paramètres d'une même fonction caractéristique d'un composant, il peut être préférable de placer, dans un circuit, deux répliques de ce composant en série, la première permettant le réglage du premier paramètre indépendamment du second paramètre, et inversement la seconde réplique permettant le réglage du second paramètre indépendamment du premier paramètre.

Les diamètres des trous, la distance entre deux trous d'une même rangée, l'écart entre deux rangées délimitant latéralement un guide d'ondes, l'épaisseur du substrat ou ses dimensions de longueur ou de largeur sont similaires à ceux de l'état de la technique.

Dans la présente description, le cas d'un substrat portant sur ses deux faces extérieures des couches conductrices a été présenté. Cet enseignement s'étend directement au cas d'un empilement plus complexe alternant substrats et couches conductrices. La dé-métallisation d'un via entre deux couches conductrices de l'empilement s'effectuant en perçant un trou dé-métallisé traversant ou un trou dé-métallisé borgne dans le composant pour supprimer le contact électrique entre ces deux couches conductrices qu'établissait ledit via.

## Revendications

1. Procédé de fabrication (100) d'un composant en technologie « guide d'onde intégré au substrat » - SIW du type comportant un substrat (14), en un matériau diélectrique, et des première et seconde couches (12, 16), en un matériau conducteur, les premier et seconde couches recouvrant deux faces opposées du substrat, **caractérisé en ce que** le procédé consiste en :

   - la réalisation (102) d'un composant générique (110) comportant uniquement une pluralité de trous métallisés (121), chaque trou métallisé formant un via entre les première et seconde couches ; et,
   - la configuration (104) du composant générique de manière à obtenir un composant final (130, 150), en dé-métallisant au moins un trou métallisé de manière à obtenir un trou dé-métallisé (142, 162), les trous métallisés (141, 161) restants étant disposés selon un motif propre à guider les ondes électromagnétiques dans le substrat d'une manière permettant de conférer une fonction caractéristique au composant final.

**2.** Procédé de fabrication (100) selon la revendication 1, dans lequel la pluralité de trous métallisés (121) du composant générique (110) forme un super-motif, le super-motif résultant de la superposition d'une pluralité de motifs, chaque motif étant associé à une fonction possible du composant final, et dans lequel la configuration (104) du composant générique consiste à sélectionner, pour le composant final, une fonction caractéristique parmi les différentes fonctions possibles en dé-métallisant les trous métallisés de la pluralité de trous métallisés qui empêchent de conférer la fonction caractéristique sélectionnée au composant final.

**3.** Procédé de fabrication (200, 300, 400) selon la revendication 1 ou la revendication 2, dans lequel la pluralité de trous métallisés (221, 321, 421) du composant générique (210, 310, 410) forme un super-motif, le super-motif résultant de la superposition d'une pluralité de motifs, chaque motif étant associé à une valeur possible d'un paramètre de la fonction caractéristique du composant final, et dans lequel la configuration (204, 304, 404) du composant générique consiste à choisir, pour le composant final, une valeur du paramètre de la fonction caractéristique en dé-métallisant les trous métallisés de la pluralité de trous métallisés qui empêchent de conférer la valeur choisie au paramètre de la fonction caractéristique du composant final.

**4.** Procédé de fabrication (100) selon l'une quelconque des revendications précédentes, dans lequel la réalisation (102) d'un composant générique comporte, pour obtenir chaque trou métallisé de la pluralité de trous métallisés (121), une étape de perçage du substrat (14) d'un trou initial, puis une étape de métallisation dudit trou initial, et dans lequel, lors de la configuration (104) du composant générique (110), la dé-métallisation d'un trou métallisé particulier consiste à percer le composant générique, à l'endroit dudit trou métallisé particulier, d'un trou ayant un diamètre plus grand que le trou initial ayant conduit, par métallisation, audit ledit trou métallisé particulier.

**5.** Procédé de fabrication (100) selon la revendication 4, dans lequel le perçage du substrat (14) pour obtenir un trou initial et/ou le perçage pour obtenir un trou dé-métallisé est réalisé au moyen d'un outil laser, les caractéristiques du faisceau laser étant choisies en fonction des dimensions caractéristiques du perçage à effectuer.

**6.** Procédé de fabrication (100) selon la revendication 2 ou la revendication 3, comportant une étape initiale de conception du super-motif consistant à optimiser chaque motif du super-motif pour tenir compte de la présence des trous dé-métallisés des autres motifs du super-motif.

**7.** Composant en technologie « guide d'onde intégré au substrat » - SIW (130, 150, 230, 250, 270, 330, 350, 430, 450, 470), **caractérisé en ce qu'**il résulte de la mise en œuvre d'un procédé de fabrication (100, 200, 300, 400) conforme à l'une quelconque des revendications précédentes.

**8.** Composant en technologie « guide d'onde intégré au substrat » - SIW (130) selon la revendication 7, **caractérisé en ce qu'**il comporte un substrat (14), en un matériau diélectrique, et des première et seconde couches (12, 16), en un matériau conducteur, les première et seconde couches recouvrant deux faces opposées du substrat, le composant comportant une pluralité de trous métallisés (141), chaque trou métallisé formant un via entre les première et seconde couches, et au moins un trou dé-métallisé (142), la pluralité de trous métallisés du composant formant un motif propre à guider les ondes électromagnétiques dans le substrat de manière à conférer une fonction caractéristique au composant.

**9.** Composant en technologie « guide d'onde intégré au substrat » - SIW (230, 330) selon l'une quelconque des revendications 7 à 8, dans lequel la fonction caractéristique du composant est une fonction de filtre, **caractérisée par** une valeur particulière d'au moins un paramètre de gain, une fonction de ligne de transmission, **caractérisée par** une valeur particulière d'au moins un paramètre de déphasage, ou une fonction de coupleur, **caractérisée par** une valeur particulière d'au moins un paramètre de couplage.

**10.** Circuit intégrant une pluralité de composants sur un même substrat (14), **caractérisé en ce que** chaque composant de la pluralité de composants est un composant en technologie « guide d'onde intégré au substrat » - SIW selon l'une quelconque des revendications 7 à 9.

## FIG.1

**FIG.2**

FIG.3

FIG.4

EP 3 945 629 A1

FIG.5

FIG.6

EP 3 945 629 A1

FIG.7

**FIG.8**

**EP 3 945 629 A1**

Europäisches
Patentamt

European
Patent Office

Office européen
des brevets

# RAPPORT DE RECHERCHE EUROPEENNE

Numéro de la demande

**EP 21 18 8056**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2012/274419 A1 (LEE HAI-YOUNG [KR] ET AL) 1 novembre 2012 (2012-11-01) | 7-10 | INV. H01P3/12 |
| Y | * alinéa [0047] - alinéa [0085]; figures | 1,4,5 | H01P11/00 |
| A | 1-3, 14-22 * | 2,3,6 | |
| | ----- | | ADD. |
| X | CN 104 767 023 A (UNIV ELECTRONIC SCIENCE & TECH) 8 juillet 2015 (2015-07-08) | 7-10 | H05K1/02 H05K3/42 |
| Y | * page 1 - page 4; figures 1-3 * | 1,4,5 | |
| A | | 2,3,6 | |
| | ----- | | |
| X | CN 104 518 262 A (UNIV ELECTRONIC SCIENCE & TECH) 15 avril 2015 (2015-04-15) | 7-10 | |
| Y | * page 1 - page 3; figures 1-6 * | 1,4,5 | |
| A | | 2,3,6 | |
| | ----- | | |
| Y | EP 1 210 848 A1 (QUALCOMM INC [US]) 5 juin 2002 (2002-06-05) * alinéa [0008] - alinéa [0016]; figures 5-9 * | 1,4,5 | |
| | ----- | | |

DOMAINES TECHNIQUES RECHERCHES (IPC)

H01P
H05K

Le présent rapport a été établi pour toutes les revendications

| Lieu de la recherche | Date d'achèvement de la recherche | Examinateur |
|---|---|---|
| La Haye | 15 décembre 2021 | Keyrouz, Shady |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 21 18 8056

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-12-2021

| Document brevet cité au rapport de recherche | Date de publication | Membre(s) de la famille de brevet(s) | Date de publication |
|---|---|---|---|
| US 2012274419 A1 | 01-11-2012 | CN 102763269 A<br>KR 20110058936 A<br>US 2012274419 A1<br>WO 2011065681 A2 | 31-10-2012<br>02-06-2011<br>01-11-2012<br>03-06-2011 |
| CN 104767023 A | 08-07-2015 | AUCUN | |
| CN 104518262 A | 15-04-2015 | AUCUN | |
| EP 1210848 A1 | 05-06-2002 | AT 484942 T<br>AU 765017 B2<br>CN 1378768 A<br>EP 1210848 A1<br>HK 1047857 A1<br>JP 4593854 B2<br>JP 2003507900 A<br>KR 20020025993 A<br>US 6360435 B1<br>WO 0115498 A1 | 15-10-2010<br>04-09-2003<br>06-11-2002<br>05-06-2002<br>07-03-2003<br>08-12-2010<br>25-02-2003<br>04-04-2002<br>26-03-2002<br>01-03-2001 |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- CN 106129553

- CN 107394322

**Littérature non-brevet citée dans la description**

- **F. PARMENT ; A. GHIOTTO ; T.P. VUONG ; J.M. DUCHAMP ; K. WU.** Low-loss air-filled substrate integrated waveguide (SIW) band-pass filter with symmetric inductive posts. *Oral, 45rd IEEE European Microwave Conférence (EuMC),* 06 Septembre 2015

- **M. BOZZI ; A. GEORGIADIS ; K. WU.** Review of substrate-integrated waveguide circuits and antennas. *IET Microwaves, Antennas & Propagation,* 06 Juin 2011, vol. 5 (8), 909-920
- **M. BOZZI ; M. PASIAN ; L. PERREGRINI ; K. WU.** On the Losses in Substrate Integrated Waveguides and Cavities. *International Journal Microwave and Wireless Technologies,* 2009